# FASCICULE DE BREVET EUROPEEN

(11) **EP 1 829 097 B1**
(45) Date de publication et mention de la délivrance du brevet: **30.04.2008**
(21) Numéro de dépôt: 05824700.8
(22) Date de dépôt: 12.12.2005
(51) Int. Cl.: H01L 21/48, G01J 5/06

(54) **COMPOSANT DE DETECTION DE RAYONNEMENTS ELECTROMAGNETIQUES NOTAMMENT INFRAROUGES**
KOMPONENTE ZUR ERKENNUNG SPEZIELL INFRAROTER ELEKTROMAGNETISCHER STRAHLUNG
COMPONENT FOR DETECTING ESPECIALLY INFRARED ELECTROMAGNETIC RADIATION

(30) Priorité: 21.12.2004 FR 0413634
(43) Date de publication de la demande: 05.09.2007
(73) Titulaire: ULIS, 38113 Veurey Voroize (FR)
(72) Inventeur: TINNES, Sébastien, F-38210 TULLINS (FR)
(74) Mandataire: Vuillermoz, Bruno
(86) Numéro de dépôt international: PCT/FR2005/051073
(87) Numéro de publication internationale: WO 2006/067344

(56) Documents cités:
- US-A- 5 420 419
- US-A- 5 763 885
- US-B1- 6 690 583
- PATENT ABSTRACTS OF JAPAN vol. 018, no. 018 (P-1673), 12 janvier 1994 (1994-01-12) & JP 05 256693 A (FUJITSU LTD), 5 octobre 1993 (1993-10-05)

## Description

L'invention concerne un composant de détection de rayonnements électromagnétiques, et notamment de rayonnement infrarouge.

Un tel composant est plus particulièrement destiné à être intégré en qualité de composant optique d'imagerie, tels que par exemple au sein d'une caméra infrarouge, fonctionnant à température ambiante, aux fins de constituer ce que dans le domaine technique considéré, on qualifie de « *rétine d'imagerie infrarouge* ».

En imagerie infrarouge, il peut s'avérer nécessaire de placer le détecteur proprement dit au sein d'une enceinte sous vide, plus ou moins poussé, afin de permettre le fonctionnement correct du ou desdits détecteurs mis en oeuvre, pour pouvoir disposer d'une sensibilité maximale aux variations de température des scènes observées.

Ainsi, il est fréquent qu'une pression inférieure à 10⁻² millibars soit nécessaire au bon fonctionnement d'un tel détecteur. Ceux-ci sont donc encapsulés dans une enceinte hermétique, au sein de laquelle le vide requis ou une atmosphère à pression réduite ont été réalisés.

Corollairement, lorsqu'il est mis en oeuvre un détecteur bolométrique, comme c'est souvent le cas dans le domaine de l'imagerie infrarouge à température ambiante, il est également nécessaire de stabiliser en température ledit ou lesdits détecteurs, afin d'obtenir de meilleures performances, outre la sensibilité requise en termes de précision quant à la température des scènes observées.

Une telle stabilisation en température est classiquement assurée au moyen d'un module thermoélectrique, par exemple du type à effet Peltier, associé avec un régulateur de type PID (pour l'expression Proportionnel Intégrale Dérivée), outre d'un capteur de température, placé à proximité ou au sein même du détecteur à stabiliser, et donc, à l'intérieur de l'enceinte définie par le boîtier précité.

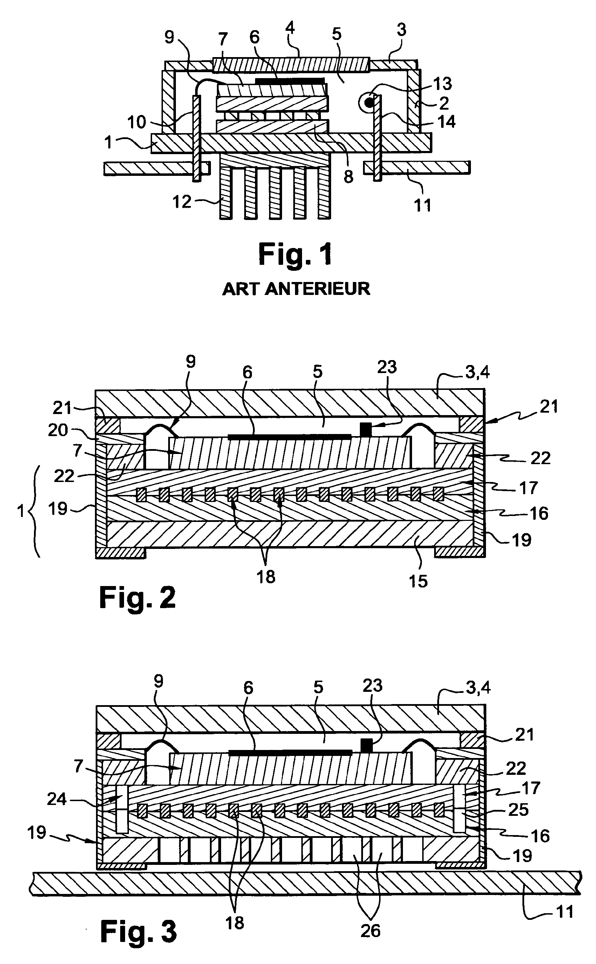

On a décrit ci-après en relation avec la figure 1, une vue schématique d'un boîtier d'encapsulation d'un détecteur bolométrique, conforme à l'art antérieur.

Celui-ci comporte fondamentalement un substrat (1), réalisé en un matériau céramique ou en métal, voire en une combinaison de ces deux types de matériaux. En l'espèce, le substrat (1) constitue la base ou le support du boîtier. Il est muni de parois latérales (2) et est obturé de manière étanche au moyen d'un couvercle (3) au niveau de sa face supérieure. Le couvercle (3) intègre une fenêtre (4) transparente au rayonnement à détecter, en l'espèce infrarouge, et par exemple transparente au rayonnement de longueurs d'onde comprises entre 8 à 12 µm ou entre 3 et 5 µm, longueurs d'onde usuelles de détection.

Une enceinte ou cavité (5) est donc définie, au sein de laquelle est susceptible de régner le vide ou une pression faible, et typiquement une pression inférieure à 10⁻² millibars. Le scellement des éléments définissant cette enceinte (5) est réalisé d'une façon telle que le taux de fuite est inférieur à 10⁻¹² mbar.1/s à l'hélium.

Au sein de cette enceinte, le substrat (1) reçoit un détecteur proprement dit, et notamment un ou plusieurs détecteurs bolométriques, positionnés en dessous de la fenêtre (4). Ce ou ces bolomètres (6) sont associés à un circuit de connectique (7), l'ensemble ou puce étant associé à un module thermoélectrique (8), solidarisé au substrat (1) par exemple par brasage ou par collage epoxy. Ce module est destiné, ainsi que déjà dit, à assurer la régulation de la température de la puce, afin notamment de faire fonction de référence compte-tenu de la variable analysée par le détecteur (6), et partant, afin de garantir une certaine reproductibilité des mesures effectuées.

L'ensemble microbolomètre et circuit de connectique (6, 7) est en outre connecté électriquement à l'extérieur, au moyen d'une connexion par câblage filaire (9), associée à une entrée/sortie standard (10) traversant ledit substrat (1), et reliée à l'électronique du dispositif dans lequel il est intégré, par exemple d'une caméra, au moyen d'un circuit d'interconnexion et d'exploitation (11).

La chaleur produite par le module thermoélectrique (8) est dissipée au moyen d'un radiateur (12), plaqué contre la surface inférieure du substrat (1), sensiblement à l'aplomb dudit module.

Afin de conserver le vide au sein de l'enceinte (5), on intègre au sein de celle-ci un moyen susceptible d'absorber et de manière générale de pomper les molécules de gaz relarguées lors de l'utilisation du composant de détection, un tel moyen étant mieux connu sous l'expression anglo-saxonne « *getter* ».

Ce getter (13) est relié à une entrée électrique de puissance (14) traversant le substrat (1), ladite entrée étant également reliée au circuit d'interconnexion (11).

Afin d'aboutir à une efficacité optimale en termes de régulation thermique, le module thermoélectrique est traditionnellement placé au sein du boîtier sous vide ou sous atmosphère à pression réduite.

Cependant, il a été envisagé de le placer à l'extérieur du boîtier, facilitant ainsi la fabrication de celui-ci, et la mise sous vide du boîtier, mais aux dépends d'une part, de l'efficacité de la régulation thermique au niveau du détecteur bolométrique, et d'autre part, de la consommation électrique dudit module thermoélectrique (voir par exemple le document US-A-5 914 488, décrivant un principe équivalent mettant en oeuvre un module chauffant en lieu et place d'un module thermoélectrique).

L'inconvénient lié à l'intégration d'un module thermoélectrique, et de manière générale d'un dispositif de stabilisation en température à l'intérieur de l'enceinte (5) définie par le boîtier, réside essentiellement dans la complexification du boîtier.

En effet, pour un tel dispositif, il est nécessaire tout d'abord d'augmenter la hauteur du boîtier, typiquement d'une valeur comprise entre 1,5 et 4,5 mm, et corollairement son encombrement.

Il convient en outre de prévoir des broches d'alimentation électrique spécifiques pour connecter électriquement le dispositif de stabilisation thermique.

Il convient enfin de limiter les températures d'assemblage et de dégazage aux températures maximum supportables par le dispositif de stabilisation thermique.

Le document US 5420419 divulgue un tel dispositif comprenant un dispositif de stabilisation thermique à l'intérieur de l'enceinte définie par le boîtier.

En revanche, dans le cas d'une configuration selon laquelle le dispositif de stabilisation ou de régulation thermique est placé à l'extérieur du boîtier, il ressort tout d'abord une consommation électrique excessive dudit dispositif, outre, également, une augmentation de l'encombrement du système complet constitué par le boîtier et le dispositif de stabilisation thermique. En outre, cela complexifie le mode d'assemblage du boîtier sur une carte électronique (mode de connexion sur la carte, température de report, etc...).

Par ailleurs, et quel que soit le lieu d'implantation du dispositif de régulation en température, c'est à dire à l'intérieur ou à l'extérieur du boîtier, son intégration à celui-ci s'avère coûteuse, notamment en raison du prix de fabrication du dispositif de régulation lui-même, mais également du surcoût engendré par l'assemblage de ce dispositif dans le boîtier, et des coûts liés aux dispositions spécifiques du boîtier, afin de recevoir un tel dispositif de régulation.

L'objet de la présente invention est essentiellement de s'affranchir de ces différents inconvénients. Elle vise ainsi à intégrer le dispositif de régulation en température, et notamment plus spécifiquement un dispositif de chauffage, dans la masse de l'une des parois constitutives du boîtier d'encapsulation, notamment dans le fond dudit boîtier. Pour ce faire, l'invention consiste de manière préférentielle à mettre en oeuvre pour la réalisation des parois du boîtier la technologie des couches de céramique cofrittées.

Selon l'invention, le composant de détection de rayonnement électromagnétique, et notamment de rayonnement infrarouge comprend :
- un boîtier définissant une enceinte placée sous vide ou sous pression réduite, boîtier dont l'une des faces est constituée par une fenêtre transparente au rayonnement à détecter, et intégrant au moins un détecteur proprement dit du rayonnement considéré, positionné à l'intérieur de ladite enceinte, sensiblement en regard de la fenêtre transparente,
- un moyen de pompage des gaz résiduels ou getter, destiné à maintenir à un niveau acceptable le vide ou la pression réduite au sein de l'enceinte,
- un dispositif de stabilisation thermique, destiné à assurer la régulation en température du ou des détecteurs.

Selon l'invention, le dispositif de stabilisation thermique est constitué par un élément résistif chauffant intégré dans la masse de l'une des parois définissant le boîtier, et notamment dans le fond.

La paroi, et donc le fond en l'espèce, est réalisé en céramique cofrittée, et comprend au moins deux couches successives de céramique, solidarisées l'une à l'autre par frittage :
- une couche supérieure, sur laquelle est solidarisée par brasage ou collage époxy le ou les détecteurs ;
- une couche inférieure, intégrant sur sa face en contact avec la couche supérieure ledit élément résistif électrique, mis en place par sérigraphie, cette couche inférieure étant solidarisée à ladite couche supérieure par frittage.

De la sorte, seul un élément résistif est intégré en tant que dispositif de stabilisation thermique dans la masse de la paroi, et plus particulièrement du fond du boîtier d'encapsulation du composant de détection de l'invention. Cet élément résistif est contrôlé par un régulateur PID externe au boîtier. Pour ce faire, il est connecté électriquement avec une ou plusieurs sorties électriques du boîtier, à l'instar de n'importe quelle autre piste de connexion par le composant. La connexion du boîtier sur la carte électronique, également dénommée circuit d'interconnexion (11) permet d'assurer la liaison du régulateur PID à l'élément résistif.

Cet élément résistif de chauffage peut présenter différents types de motifs, tels que notamment linéaires, en serpentin, en spirale, etc...l'objectif visé étant d'aboutir à la température la plus uniforme possible, au niveau du détecteur dont on souhaite réguler ou stabiliser la température.

Selon une autre caractéristique de l'invention, on intègre également au sein de la masse de la paroi, et notamment du fond du boîtier, un dispositif visant à augmenter la résistance thermique entre le dispositif de chauffage intégré précité, et le milieu extérieur.

A cet effet, on associe le fond réalisé tel que décrit précédemment à une troisième couche inférieure, pourvue d'un certain nombre de cavités de toute forme remplies d'air, et ouvertes sur le milieu extérieur, limitant ainsi au maximum la surface de contact entre le boîtier et le circuit imprimé d'interconnexion (11).

Selon une autre forme de réalisation de l'invention, une seconde cavité est définie au fond du boîtier, assurant la fonction d'isolement thermique, ladite seconde cavité étant en communication avec la cavité supérieure recevant notamment l'ensemble constitué par le ou les détecteurs et son (leur) circuit(s) de connectique (6, 7), par le biais d'évidements traversants ménagés au sein des couches de céramiques cofrittées intégrant l'élément résistif du dispositif de stabilisation thermique.

La manière de réaliser l'invention et les avantages qui en découlent ressortiront mieux des exemples de réalisation qui suivent, donnés à titre indicatif et non limitatif à l'appui des figures annexées.

La figure 1 est, comme déjà dit, une représentation schématique en section d'un dispositif de l'art antérieur.

La figure 2 est une représentation schématique en section d'une première forme de réalisation du composant de détection conforme à l'invention.
La figure 3 est une représentation schématique en section d'une seconde forme de réalisation du composant de détection conforme à l'invention.
La figure 4 est une représentation schématique en section d'une troisième forme de réalisation du composant de détection conforme à l'invention, dont la figure 5 est une vue du dessus, après escamotage de la fenêtre transparente au rayonnement à détecter.

Les éléments communs entre le schéma illustrant l'art antérieur et ceux illustrant l'invention portent ci-après les mêmes références numériques.

Le composant de détection conforme à l'invention comporte, comme dans l'art antérieur, un boîtier hermétiquement scellé, de telle sorte à limiter les fuites au moins à une valeur voisine de 10⁻¹² mbar.1/s à l'hélium.

Ce boîtier comporte un substrat en céramique cofritté (1), décrit ci-après plus en détail, sur lequel est rapporté par brasage ou par collage epoxy un ou plusieurs microbolomètres (6) associé(s) à un circuit de connectique (7). Le circuit de connectique (7) est lui-même avantageusement muni d'un capteur de température (23), dont le but est d'optimiser la régulation thermique de la puce électronique constituée par l'ensemble (6, 7), et ce de manière connue.

Ce boîtier est obturé au niveau de sa face supérieure par un couvercle (3), intégrant une fenêtre (4) transparente au rayonnement à détecter, en l'espèce transparente au rayonnement infrarouge.

Selon une caractéristique fondamentale de l'invention, un élément résistif chauffant, appartenant à un dispositif de stabilisation thermique de la cavité définie à l'intérieur du boîtier, contribuant à la régulation thermique du ou des détecteurs bolométriques (6), est intégré dans la masse du substrat (1).

Dans l'exemple décrit, le substrat (1) est un substrat tri-couches. La couche intermédiaire (16), réalisée en céramique, reçoit sur sa face supérieure, c'est à dire sur sa face dirigée vers la puce (6, 7) un élément résistif chauffant (18).

Afin d'isoler électriquement cet élément résistif de ladite puce (6, 7), une couche supérieure (17), également réalisée en céramique, est positionnées sur la couche intermédiaire (16).

L'ensemble (16, 17, 18) est destiné à assurer un échauffement uniforme de la puce (6, 7) par effet Joule, afin de réaliser une régulation en température spatiale et temporelle de celle-ci, quelques degrés au-dessus de la température ambiante.

L'élément résistif chauffant (18) est, comme déjà dit, appliqué par sérigraphie de conducteurs électriques sous forme d'encre, sur des feuilles de céramique crues. De manière connue, ces feuilles de céramique, avant d'être cofrittées et donc cuites, se présentent sous forme non rigide, donc molles ou souples, que la technique considérée qualifie de « crues ».

Ainsi, plusieurs feuilles de céramique avec des motifs et des routages de conducteur différents peuvent être superposées, jusqu'à aboutir au profil souhaité de l'élément résistif chauffant, et corollairement à la plus grande uniformité possible d'échauffement de la puce sus-jacente.

La communication électrique entre les pistes conductrices sur deux niveaux différents est assurée par des vias (non représentés).

Une fois les feuilles de céramiques crues sérigraphiées assemblées, alignées et pressées à l'aide d'un outillage bien connu de l'homme du métier, on procède à leur frittage à haute température et sous pression, afin d'aboutir à une liaison des feuilles entre elles. L'ensemble ainsi constitué est alors rigide et peut être découpé en modules individuels constituant l'ensemble des deux couches (16, 17) par exemple du substrat (1). Cet ensemble (16, 17) est associé à une couche ou deux couches en céramique (15), afin d'isoler l'élément résistif de chauffage (18) du circuit imprimé d'interconnexion (11).

En outre, la cavité (5) proprement dite est définie par ajout de couches de céramique périphériques (21, 22) sur le substrat (1), pendant l'élaboration dudit substrat. Ainsi, les couches de céramique (15, 16, 17, 21, 22) sont toutes assemblées ensemble et cofrittées simultanément.

Deux familles technologiques principales de frittage de telles céramiques sont connues :
- la technologie dite « LTCC » pour l'expression anglo-saxonne « *low temperature cofired ceramic* », dont le frittage est réalisé autour de 800 °C, et pour laquelle les conducteurs électriques sont réalisés avec des encres à base d'argent ;
- la technologie « HTCC » pour l'expression anglo-saxonne "*high temperature cofired ceramic*", dont la température de frittage est alors de l'ordre de 1.500 °C, et pour laquelle les conducteurs électriques sont réalisés avec des encres à base de métaux réfractaires du type tungstène.

Dans la forme de réalisation décrite en relation avec la figure 2, on met en oeuvre plus particulièrement la technologie HTCC. En effet, les conducteurs électriques internes de type tungstène sont, de manière connue, plus résistifs que les conducteurs à base d'argent, favorisant ainsi la mise en oeuvre des pistes conductrices en tant que résistance pour le chauffage par effet Joule requis de la puce.

En outre, la technologie HTCC permet de travailler avec un substrat de type alumine, avec une conduction thermique moyenne de 15 à 20 W/m/K, voire avec un substrat de type AIN (Nitrure d'Aluminium) de meilleure conduction thermique (180 W/m/K), et donc favorisant la diffusion de la chaleur au niveau de la puce.

L'illustration de la figure 2 est une vue en section. On peut donc observer l'élément résistif chauffant (18), dont on peut supposer qu'il représente une succession de serpentins ou de spirales, étant rappelé que l'objectif recherché est constitué par la diffusion la plus uniforme possible de la chaleur au niveau de la puce à réguler en température.

L'utilisation de la sérigraphie permet de disposer d'une très grande liberté en termes de forme ou de « design » conféré à l'élément résistif.

Typiquement, on cherche à dissiper de 10 mW à 5 W.

Avantageusement, afin de réduire les pertes thermiques, et donc corollairement réduire la consommation électrique du dispositif, l'invention propose de réduire la surface de conduction thermique ou de contact entre le substrat (1), tel que constitué précédemment, et le circuit imprimé d'interconnexion (11). Il s'ensuit un mode de réalisation de l'invention, décrit ci-après en relation avec la figure 3.

Ainsi, aux deux couches de céramique cofrittée (16, 17) mentionnées précédemment, est adjointe une couche (15), en même matériau, dont toute la zone centrale est pourvue de cavités (26) de profil quelconque et notamment parallélépipédique, cylindrique ou autre, reliées au milieu extérieur. Ce faisant, on limite les zones de contact entre le substrat et le circuit d'interconnexion (11), et corollairement les pertes thermiques par conduction inhérentes au matériau constitutif dudit substrat.

Les cavités (26) sont réalisées de telle sorte à éviter tout risque d'affaissement des couches supérieures (16) et (17) du substrat, par exemple en respectant un ratio d'au moins quatre entre les dimensions des cavités, et celles des piliers définissant lesdites cavités. Par exemple, on choisit des cavités de 2 mm de large réparties selon un pas de 2,5 mm. Corollairement, les bords périphériques de la couche (15) ne présentent pas de telles cavités, afin de permettre notamment la mise en place au niveau des parois latérales de contacts électriques (19) acheminant les signaux électriques entre la puce (6, 7) ou l'élément résistif chauffant (18) et le circuit imprimé d'interconnexion (11).

Les couches supérieures (16) et (17) peuvent en outre également présenter des cavités (24, 25), afin de limiter les pertes par conduction au niveau des faces latérales de la céramique constitutive du substrat.

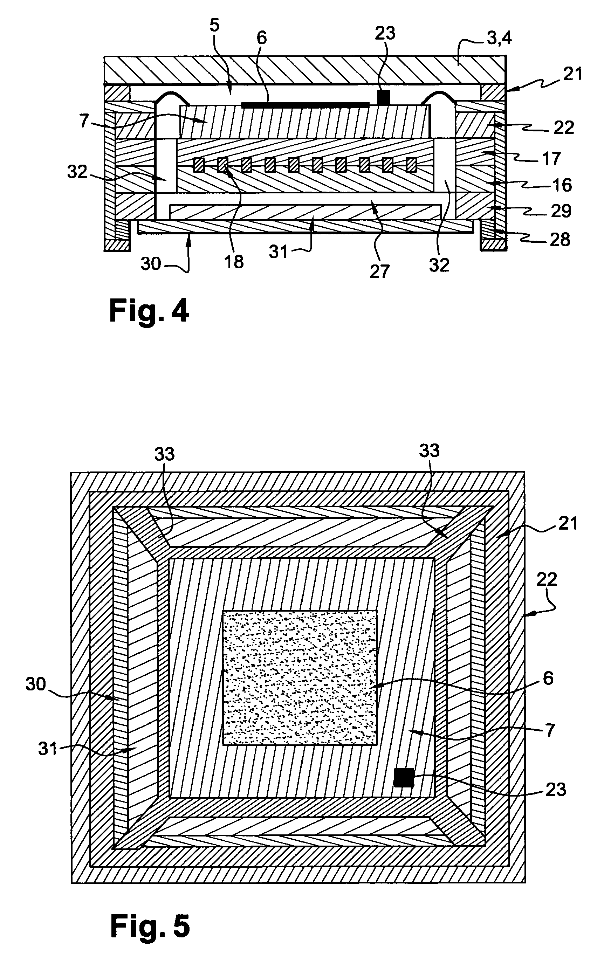

Un autre mode de réalisation de l'invention, décrit ci-après en relation avec les figures 4 et 5, peut également être envisagé, toujours dans l'objectif de limiter les pertes thermiques.

Au sein de cette forme de réalisation, l'ensemble (16, 17, 18) est maintenu à l'instar de ce qui a été décrit avec la figure 2. Ce faisant, une cavité supérieure (5) est ainsi défini dans la partie supérieure du boîtier, ladite cavité recevant notamment la puce (6, 7), et étant maintenue, ainsi que rappelée, sous un vide voisin de 10⁻² millibars.

Corollairement, on définit une seconde cavité, dite cavité « inférieure » ou « cavité d'isolement thermique » (27), par la mise en oeuvre de deux niveaux supplémentaires de couches de céramique (28, 29), ladite cavité étant obturée, typiquement par brasage, au niveau de sa base inférieure par une plaque métallique (30). Cette dernière est susceptible de recevoir un getter (31), reporté par dépôt sous vide type PVD (pour l'expression anglo-saxonne Physical Vapor Deposition) ou rapporté par soudure électrique sur la plaque métallique (30), ou par tout autre moyen.

Les cavités supérieure (5) et inférieure (27) communiquent entre elles au moyen d'évidements (32) ménagés au sein de l'ensemble (16, 17). Ce faisant, on maintient un même niveau de vide au sein de ces deux cavités.

Les couches (16, 17) sont en continuité mécanique avec le reste du boîtier au moyen d'au moins un élément, et par exemple au moyen de quatre bras ou jonctions (33), qui d'une part, assurent le soutien mécanique de la puce (6, 7) au dessus de la cavité inférieure (27) d'isolement thermique, et d'autre part, permettent le cheminement du contact électrique de l'élément résistif chauffant (18) vers les sorties appropriées du boîtier, à l'aide d'un conducteur électrique sérigraphié simultanément avec ledit élément résistif (18). Ces quatre bras ou jonctions (33) sont par exemple ménagés sensiblement au quatre angles des couches (16, 17).

Les évidements (32) permettent d'augmenter l'isolation thermique dans le plan de la puce (6, 7), réduisant ainsi les pertes thermiques inhérentes à la conduction par le biais des jonctions (33).

La cavité (27) conditionnée sous vide, assure donc l'isolation thermique entre l'élément résistif de chauffage (18) et le fond du boîtier principalement constitué par la couche inférieure céramique (28), elle-même en contact direct ave le milieu extérieur.

Cette isolation thermique doublée de l'isolation thermique inhérente aux évidements (32), permet ainsi une diminution significative de la consommation électrique de l'élément résistif chauffant en raison des pertes thermiques réduites.

De plus, ce mode de réalisation permet de conférer une certaine uniformité en température à l'intérieur du boîtier, ce dernier devenant nettement moins sensible aux variations des conditions environnementales extérieures et à la configuration d'assemblage sur la carte électronique, d'une caméra par exemple.

Il ressort de la présente invention un certain nombre d'avantages, dont les principaux vont être décrits ci-après.

Tout d'abord, en termes d'encombrement : lorsque le fond d'un boîtier d'encapsulation est constitué d'au moins deux niveaux de céramique, ce qui est assez fréquent, l'ajout d'un motif sérigraphié n'a pas d'impact sur l'encombrement.

On dispose donc d'un dispositif d'encapsulation d'encombrement extrêmement faible, puisque l'enceinte dudit boîtier est réduite de l'épaisseur du module thermoélectrique. Si en revanche, il s'avère nécessaire de rajouter un niveau de céramique au niveau du substrat, celui-ci présente une épaisseur typique comprise entre 0,2 et 0,5 mm, qui reste cependant très faible, au regard des technologies antérieures, qui induisent l'augmentation de 1,5 à 4,5 mm supplémentaires.

Le surcoût engendré est limité à la céramique supplémentaire au niveau du substrat avec sérigraphie. Il reste cependant marginal au regard du coût du dispositif de régulation thermique externe ajouté sur le fond d'un boîtier, tel que le connaît l'art antérieur.

En outre, la haute température permettant de réaliser l'étape de frittage ne constitue pas un facteur limitant au regard des températures d'assemblage ou de dégazage, contrairement aux dispositifs mettant en oeuvre un organe de régulation thermique type Peltier.

Enfin, le motif résistif ou élément chauffant est relié directement aux sorties du boîtier pendant l'élaboration du produit, et donc il n'y a plus d'étape particulière de connexion du dispositif de régulation sur le boîtier.

## Revendications

1. Composant de détection de rayonnement électromagnétique, et notamment de rayonnement infrarouge comprenant:
- un boîtier définissant une enceinte (5) placée sous vide ou sous pression réduite, boîtier dont l'une des faces est constituée par une fenêtre (4) transparente au rayonnement à détecter, ladite enceinte intégrant au moins un détecteur (6) proprement dit du rayonnement considéré, positionné sensiblement en regard de la fenêtre transparente,
- un moyen de pompage (13) des gaz résiduels ou getter, destiné à maintenir à un niveau acceptable le vide ou la pression réduite au sein de l'enceinte (5),
- un dispositif de stabilisation thermique (18), destiné à assurer la régulation du ou des détecteurs (6) en température,
***caractérisé* en ce que** le dispositif de stabilisation thermique est constitué d'un élément résistif chauffant (18), intégré dans la masse de l'une des parois définissant le boîtier.

2. Composant de détection de rayonnement électromagnétique selon la revendication 1, ***caractérisé* en ce que** l'élément résistif chauffant (18) constitutif du dispositif de stabilisation thermique est intégré dans la masse du fond du boîtier, et notamment dans le substrat (1) sur lequel sont rapportés le ou les détecteurs (6) associés à un circuit de connectique (7).

3. Composant de détection de rayonnement électromagnétique selon la revendication 2, ***caractérisé* en ce que** le substrat (1) est réalisé en céramique, et **en ce qu'**il comprend au moins deux couches solidarisées l'une à l'autre par frittage :
- une couche supérieure (17), sur laquelle est solidarisée par brasage ou collage époxy le ou les détecteurs (6, 7) ;
- et une couche inférieure (15, 16), intégrant sur sa face en contact avec la couche supérieure (17) l'élément résistif chauffant (18), mis en place par sérigraphie, ladite couche inférieure (16) étant solidarisée à la couche supérieure (17) par frittage.

4. Composant de détection de rayonnement électromagnétique selon l'une des revendications 1 à 3, ***caractérisé* en ce que** l'élément résistif chauffant (18) constitutif du dispositif de stabilisation thermique est contrôlé par un régulateur externe au boîtier, notamment type PID.

5. Composant de détection de rayonnement électromagnétique selon l'une des revendications 3 et 4, ***caractérisé* en ce que** l'élément résistif chauffant (18) constitutif du dispositif de stabilisation thermique présente différents types de motifs, notamment linéaire, en serpentin, en spirale, afin d'aboutir à la température la plus uniforme possible au niveau du ou des détecteurs (6).

6. Composant de détection de rayonnement électromagnétique selon l'une des revendications 3 à 5, ***caractérisé* en ce que** l'on intègre également au sein de la masse du substrat (1) un moyen visant à augmenter la résistance thermique entre l'élément résistif chauffant (18) constitutif du dispositif de stabilisation thermique et le circuit d'interconnexion ou de lecture (11).

7. Composant de détection de rayonnement électromagnétique selon la revendication 6, ***caractérisé* en ce que** ledit moyen d'augmentation de la résistance thermique est constitué par la réalisation de cavités (26) de profil quelconque au sein de la couche inférieure (15) du substrat (1), visant à diminuer la surface de contact entre ledit substrat et le circuit imprimé d'interconnexion (11).

8. Composant de détection de rayonnement électromagnétique selon la revendication 6, ***caractérisé* en ce que** ledit moyen d'augmentation de la résistance thermique est constitué par une seconde cavité (27), dite cavité d'isolement thermique, définie au fond du boîtier, et communiquant avec la cavité supérieure (5) recevant notamment l'ensemble constitué par le ou les détecteurs (6) et son (leur) circuit(s) de connectique (7), par le biais d'évidements traversants (32) ménagés au sein des couches de céramiques cofrittées (16, 17) intégrant l'élément résistif chauffant (18) du dispositif de stabilisation thermique.

9. Composant de détection de rayonnement électromagnétique selon la revendication 8, ***caractérisé* en ce que** la cavité d'isolement thermique (27) est définie par des couches de céramique cofrittées (28, 29), et **en ce que** ladite cavité (27) est obturée au niveau de sa base par une plaque métallique (30), susceptible de recevoir un dispositif de type « getter ».

10. Composant de détection de rayonnement électromagnétique selon l'une des revendications 8 et 9, ***caractérisé* en ce que** les couches de céramique cofrittée (16, 17) recevant l'élément résistif chauffant (18) constitutif du dispositif de stabilisation thermique (16, 17) sont en continuité mécanique avec le reste du boîtier au moyen d'au moins un élément (33), destiné d'une part, à assurer le soutien mécanique de l'ensemble détecteur(s) (6) - circuit de connectique (7) au dessus de la cavité inférieure (27) d'isolement thermique, et d'autre part, de permettre le cheminement du contact électrique de l'élément résistif chauffant (18) vers les sorties appropriées du boîtier, à l'aide d'un conducteur électrique sérigraphié simultanément avec ledit élément résistif (18).

11. Composant de détection de rayonnement électromagnétique selon la revendication 10, ***caractérisé* en ce que** l'élément assurant la continuité mécanique des couches de céramique coffritée (16, 17) avec le reste du boîtier est constitué de quatre bras ou jonctions (33), ménagés sensiblement au quatre angles desdites couches.

## Claims

1. A component for detecting electromagnetic radiation, particularly infrared radiation comprising:
- a housing defining a chamber (5) placed under a vacuum or underpressure, one of the faces of said housing consisting of a window (4) which is transparent to the radiation to be detected, said chamber comprising at least one detector (6) which is used to detect the radiation in question and is arranged inside said chamber essentially against the transparent window,
- a means for pumping (13) the residual gases or getter in order to maintain the vacuum or underpressure in the chamber (5) at an acceptable level,
- a thermal stabilisation device (18) for ensuring the regulation of the detector(s) in terms of temperature,
***characterised* in that** the thermal stabilisation device consists of a heating resistive element (18) which is integrated into the mass of one of the walls defining the housing.

2. A component for detecting electromagnetic radiation as claimed in claim 1, ***characterised* in that** heating resistive element (18) of the thermal stabilisation device is integrated into the mass of the base of the housing, particularly in substrate (1) on which the detector(s) (6) associated with an interfacing circuit (7) is/are mounted.

3. A component for detecting electromagnetic radiation as claimed in claim 2, ***characterised* in that** substrate (1) is made of a ceramic and **in that** it comprises at least two layers attached to each other by firing:
- an upper layer (17) on which the detector(s) (6, 7) is/are attached by soldering or epoxy bonding;
- and a lower layer (15, 16) that includes, on its face that is in contact with upper layer (17), heating resistive element (18) obtained by screen printing, said lower layer (16) being attached to upper layer (17) by firing.

4. A component for detecting electromagnetic radiation as claimed in any of claims 1 to 3, ***characterised* in that** heating resistive element (18) of the thermal stabilisation device is monitored by a controller outside the housing, particularly a controller of the PID type.

5. A component for detecting electromagnetic radiation as claimed in any of claims 3 and 4, ***characterised* in that** heating resistive element (18) of the thermal stabilisation device has various types of patterns, particularly straight, coiled or spiral in order to ensure that the temperature at the level of detector(s) (6) is as uniform as possible.

6. A component for detecting electromagnetic radiation as claimed in any of claims 3 to 5, ***characterised* in that** means for increasing the thermal resistance between heating resistive element (18) of thermal stabilisation device and interconnection or read circuit (11) is also integrated into the mass of substrate (1).

7. A component for detecting electromagnetic radiation as claimed in claim 6, ***characterised* in that** said means for increasing the thermal resistance consists of cavities (26) having any profile in lower layer (15) of substrate (1) designed to reduce the contact surface area between said substrate and printed interconnection circuit (11).

8. A component for detecting electromagnetic radiation as claimed in claim 6, ***characterised* in that** said means for increasing the thermal resistance consists of a second so-called thermal insulation cavity (27) defined in the base of the housing and communicating with upper cavity (5) which accommodates, in particular, the assembly consisting of detector(s) (6) and its/their interfacing circuit(s) (7) via through-openings (32) made in cofired ceramic layers (16, 17) that integrate heating resistive element (18) of the thermal stabilisation device.

9. A component for detecting electromagnetic radiation as claimed in claim 8, ***characterised* in that** thermal insulation cavity (27) is defined by cofired ceramic layers (28, 29) and **in that** said cavity (27) is closed off at the level of its base by a metal plate (30) capable of accommodating a "getter" type device.

10. A component for detecting electromagnetic radiation as claimed in any of claims 8 and 9, ***characterised* in that** cofired ceramic layers (16, 17) accommodating heating resistive element (18) of thermal stabilisation device (16, 17) are physically continuous with the rest of the housing thanks to at least one element (33) designed firstly to physically support detector(s) (6)-interfacing circuit (7) assembly above lower thermal insulation cavity (27) and secondly to allow routing of the electrical contact of heating resistive element (18) to the appropriate outputs of the housing by means of an electrical conductor that is screen printed at the same time as said resistive element (18).

11. A component for detecting electromagnetic radiation as claimed in claim 10, ***characterised* in that** the element that ensures physical continuity of cofired ceramic layers (16, 17) with the rest of the housing consists of four arms or junctions (33) placed substantially in the four corners of said layers.

## Patentansprüche

1. Bauteil zur Erfassung von elektromagnetischer Strahlung, und insbesondere von Infrarotstrahlung, Folgendes umfassend:
- ein Gehäuse, das einen geschlossenen Raum (5) bildet, der unter Unterdruck oder unter vermindertem Druck steht, wobei eine der Seiten des Gehäuses durch ein für die zu erfassende Strahlung durchlässiges Fenster (4) gebildet ist, wobei der geschlossene Raum mindestens einen Sensor (6) für die betreffende Strahlung aufweist, der im Wesentlichen gegenüber dem durchlässigen Fenster angeordnet ist,
- eine Pumpeinrichtung (13) für Restgase oder Getterpumpe, die dazu bestimmt ist, den Unterdruck oder den verminderten Druck im Inneren des geschlossenen Raums (5) auf einem akzeptablen Niveau zu halten,
- eine Wärmestabilisationsvorrichtung (18), die dazu bestimmt ist, die Temperaturregelung des Sensors oder der Sensoren (6) sicherzustellen,
**dadurch gekennzeichnet, dass** die Wärmestabilisationsvorrichtung aus einem Wärmewiderstandselement (18) besteht, das in die Masse einer der das Gehäuse bildenden Wände eingebunden ist.

2. Bauteil zur Erfassung von elektromagnetischer Strahlung nach Anspruch 1, **dadurch gekennzeichnet, dass** das Wärmewiderstandselement (18), das ein Bestandteil der Wärmestabilisationsvorrichtung ist, in die Masse der Rückwand des Gehäuses und insbesondere in das Substrat (1) eingebunden ist, auf dem der Sensor oder die Sensoren (6) angebracht ist bzw. sind, der bzw. die mit einem Anschlussschaltkreis verbunden ist/sind.

3. Bauteil zur Erfassung von elektromagnetischer Strahlung nach Anspruch 2, **dadurch gekennzeichnet, dass** das Substrat (1) aus Keramik hergestellt ist, und dass es mindestens zwei Schichten umfasst, die durch Sintern fest miteinander verbunden sind:
- eine obere Schicht (17), auf welcher der Sensor oder die Sensoren (6, 7) durch Anlöten oder Epoxidklebung fest angebracht ist bzw. sind;
- und eine untere Schicht (15, 16), die auf ihrer mit der oberen Schicht (17) in Kontakt stehenden Seite das durch Siebdruck aufgebrachte Wärmewiderstandselement (18) aufweist, wobei die untere Schicht (16) mit der oberen Schicht (17) durch Sintern fest verbunden ist.

4. Bauteil zur Erfassung von elektromagnetischer Strahlung nach einem der Ansprüche 1 bis 3, **dadurch gekennzeichnet, dass** das Wärmewiderstandselement (18), das ein Bestandteil der Wärmestabilisationsvorrichtung ist, durch einen außen am Gehäuse angeordneten Regler, insbesondere von der Bauart eines PID-Reglers geregelt wird.

5. Bauteil zur Erfassung von elektromagnetischer Strahlung nach einem der Ansprüche 3 und 4, **dadurch gekennzeichnet, dass** das Wärmewiderstandselement (18), das ein Bestandteil der Wärmestabilisationsvorrichtung ist, verschiedene Arten von insbesondere linearen, schlangenförmigen, spiralförmigen Druckmustern aufweist, um im Bereich des Sensors oder der Sensoren (6) die gleichmäßigste Temperatur zu erreichen, die möglich ist.

6. Bauteil zur Erfassung von elektromagnetischer Strahlung nach einem der Ansprüche 3 bis 5, **dadurch gekennzeichnet, dass** ebenfalls im Inneren der Masse des Substrats (1) eine Einrichtung eingebunden ist, um den thermischen Widerstand zwischen dem Wärmewiderstandselement (18), das ein Bestandteil der Wärmestabilisationsvorrichtung ist, und der Verbindungs- oder Leseschaltung (11) zu erhöhen.

7. Bauteil zur Erfassung von elektromagnetischer Strahlung nach Anspruch 6, **dadurch gekennzeichnet, dass** die Einrichtung zum Erhöhen des thermischen Widerstands durch die Herstellung von Hohlräumen (26) mit beliebigem Profil im Inneren der unteren Schicht (15) des Substrats (1) gebildet ist, um die Kontaktfläche zwischen dem Substrat und der gedruckten Verbindungsschaltung (11) zu verkleinern.

8. Bauteil zur Erfassung von elektromagnetischer Strahlung nach Anspruch 6, **dadurch gekennzeichnet, dass** die Einrichtung zum Erhöhen des thermischen Widerstands durch einen zweiten Hohlraum (27), Wärmeisolierungshohlraum genannt, gebildet ist, der an der Rückwand des Gehäuses ausgebildet ist und mit dem oberen Hohlraum (5), der insbesondere die Einheit bestehend aus dem Sensor oder den Sensoren (6) und seinem (ihren) Anschlussschaltkreis(en) (7) aufnimmt, über quer hindurch verlaufende Ausnehmungen (32) in Verbindung steht, die im Inneren der zusammen gesinterten Keramikschichten (16, 17) ausgebildet sind, in die das Wärmewiderstandselement (18) der Wärmestabilisationsvorrichtung eingebunden ist.

9. Bauteil zur Erfassung von elektromagnetischer Strahlung nach Anspruch 8, **dadurch gekennzeichnet, dass** der Wärmeisolierungshohlraum (27) durch zusammen gesinterte Keramikschichten (28, 29) gebildet ist, und dass der Hohlraum (27) im Bereich seiner Basis mit einer Metallplatte (30) verschlossen ist, die eine Vorrichtung von der Art "Getter" aufnehmen kann.

10. Bauteil zur Erfassung von elektromagnetischer Strahlung nach einem der Ansprüche 8 und 9, **dadurch gekennzeichnet, dass** die zusammen gesinterten Keramikschichten (16, 17), die das Wärmewiderstandselement (18) aufnehmen, das ein Bestandteil der Wärmestabilisationsvorrichtung (16, 17) ist, mit dem Rest des Gehäuses mechanisch durchgehend ist, und zwar mittels wenigstens eines Elements (33), das dazu bestimmt ist, einerseits den mechanischen Halt der Einheit aus Sensor(en) (6) - Anschlussschaltkreis (7) über dem unteren Wärmeisolierungshohlraum (27) sicherzustellen, und andererseits die Weiterleitung des elektrischen Kontakts des Wärmewiderstandselements (18) zu den geeigneten Ausgängen des Gehäuses mittels eines elektrischen Leiters zuzulassen, der gleichzeitig mit dem Wärmewiderstandselement (18) durch Siebdruck hergestellt wurde.

11. Bauteil zur Erfassung von elektromagnetischer Strahlung nach Anspruch 10, **dadurch gekennzeichnet, dass** das Element, das die mechanische Durchgängigkeit der zusammen gesinterten Keramikschichten (16, 17) mit dem Rest des Gehäuses sicherstellt, aus vier Armen oder Übergängen (33) besteht, die im Wesentlichen in vier Winkeln der Schichten ausgebildet sind.
